# EUROPEAN PATENT APPLICATION

(11) **EP 1 382 656 A1**
(43) Date of publication of application: **21.01.2004**
(21) Application number: 03008631.8
(22) Date of filing: 15.04.2003
(51) Int. Cl.: C09K 5/06, C09K 5/02, B01J 13/02

(54) **Heat-absorbing particle**

(30) Priority: 15.07.2002 US 195616
(71) Applicant: Huang, Kun-Hsiang, Feng-Shan City, Kaohsiung Hsien (TW)
(72) Inventor: Huang, Kun-Hsiang, Feng-Shan City, Kaohsiung Hsien (TW)
(74) Representative: Casalonga, Axel

(57) **Abstract**

A heat-absorbing particle has a diameter of 1∼1000 µm and comprises a shell portion (1) and a core portion (2). The shell portion (1) is made of a high molecular polymer selected from a group consisting of melamine-formaldehyde, urea-formaldehyde resins, polyurethanes, and acrylics. The core portion (2) is made of a heat-absorbing material that has a melting point at about 35°C-70°C and that is selected from a group consisting of straight chain alkanes, alcohols, and organic acids. A weight of the shell portion (1) is about 1/20 - 1/2 of that of the core portion (2). The heat-absorbing particle may be processed to provide a coating material that may be coated on a surface of an object for heat-dissipation and/or antioxidation. The heat-absorbing material may further include a dye for providing a colorful appearance for the coating.

## Description

### Background of the Invention

### 1. Field of the Invention

The present invention relates to a heat-absorbing particle. In particular, the present invention relates to a heat-absorbing particle that can be coated on a surface of an object for heat-dissipation and/or antioxidation.

### 2. Description of the Related Art

Computer components, electronic products, mechanical parts, etc. generate heat during operation. It is common to mount fans, fins, heat conductive tubes, and other heat-dissipating members on these devices for expediting dissipation of the generated heat. Heat energy causes two kinds of change in a substance: one in temperature, and the other in phase, the latter being known as "latent heat." Ordinary heat-dissipating members are made of copper or aluminum that absorbs heat and thus incurs a direct increase in the temperature. These heat-dissipating members provided more or less expected heat-dissipating effect. However, due to recent improvement in the operation speed of the computers, the temperature of the heat-generating devices in the computers may rise up to 100°C or even higher. And these conventional heat-dissipating members or devices were found to be incapable of dissipating such a large amount of heat.

The surface of the heat-dissipating members is sometimes covered with a layer of paint or coating for preventing oxidation and/or providing an aesthetically pleasing appearance. However, the paint or coating adversely affects the heat-dissipating effect.

U.S. Patent No. 5,456,852 to Isiguro issued on Oct. 10, 1995 discloses a microcapsule for heat-storing material which encapsulates a compound capable of undergoing phase transitions, the microcapsule containing a high-melting compound having a melting point 20°C-110°C higher than that of the compound capable of undergoing phase transition. However, the compound capable of undergoing phase transition has a melting point at about 1°C-37°C, which is incapable of effectively absorbing the heat generated by the recently developed computers.

### Summary of the Invention

An object of the present invention is to provide a heat-absorbing particle that can be coated on a surface of an object for heat-dissipation and/or antioxidation. For example, the heat-absorbing particle can be coated on a heat-dissipating member or a heat source for absorbing heat from the heat-dissipating member or the heat source and then dissipating the absorbed heat to the environment. The coating also provides an antioxidation effect.

A heat-absorbing particle in accordance with the present invention has a diameter of 1∼1000 µm and comprises a shell portion and a core portion. The shell portion is made of a high molecular polymer selected from a group consisting of melamine-formaldehyde, urea-formaldehyde resins, polyurethanes, and acrylics. The core portion is made of a heat-absorbing material that has a melting point at about 35°C-70°C and that is selected from a group consisting of straight chain alkanes, alcohols, and organic acids. A weight of the shell portion is about 1/20 - 1/2 of that of the core portion.

Preferably, the heat-absorbing material is selected from a group consisting of paraffin, docosane, tetracosane, tetradecanol, hexadecanol, octodecanol, dodecanic acid, tetradecanoic acid, and hexadecanoic acid.

The heat-absorbing particle may be processed to provide a coating material that may be coated on a surface of a heat-dissipating member or heat source, thereby achieving the heat-dissipating purpose. The heat-absorbing material may further include a dye for providing a colorful appearance for the coating.

Other objects, advantages, and novel features of the invention will become more apparent from the following detailed description when taken in conjunction with the accompanying drawings.

### Brief Description of the Drawings

Fig. 1 is a schematic sectional view of a heat-absorbing particle in accordance with the present invention.
Fig. 2 is a schematic flowchart illustrating preparation of the heat-absorbing particle in accordance with the present invention and subsequent coating process.

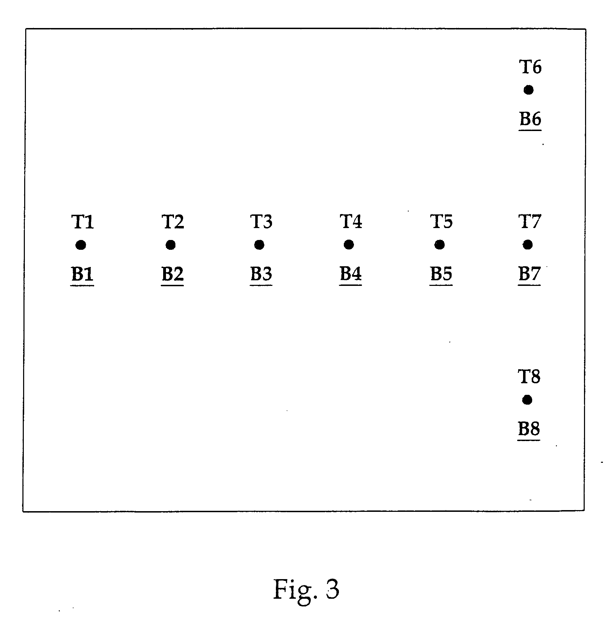

Fig. 3 is a plan view showing locations of temperature measuring points on an aluminum plate for test.

### Detailed Description of the Preferred Embodiment

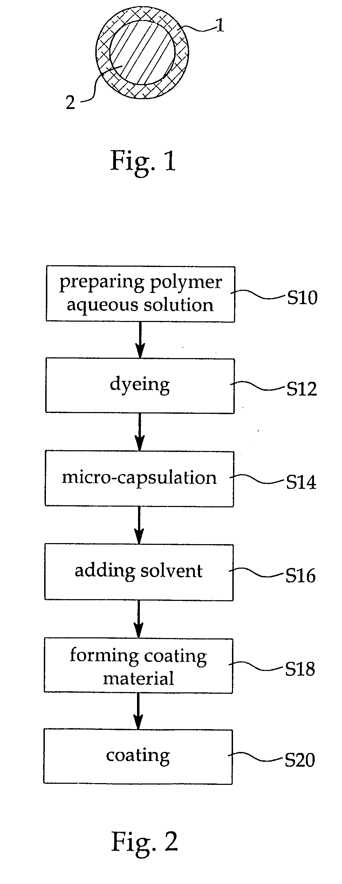

Referring to Fig. 1, a heat-absorbing particle in accordance with the present invention is a micro-capsular particle with a diameter of 1∼1000 µm and generally comprises a shell portion 1 and a core portion 2. The shell portion 1 is made of a high molecular polymer selected from a group consisting of melamine-formaldehyde, urea-formaldehyde resins, polyurethanes, and acrylics.

The core portion 2 is made of a heat-absorbing material that has a melting point at about 35°C-70°C and that is selected from a group consisting of straight chain alkanes, alcohols, and organic acids. Preferably, the core portion 2 is made of a heat-absorbing material selected from a group consisting of paraffin, docosane, tetracosane, tetradecanol, hexadecanol, octodecanol, dodecanic acid, tetradecanoic acid, and hexadecanoic acid. The weight of the shell portion 1 is about 1/20 - 1/2 of that of the core portion 2.

The heat-absorbing material uses latent heat to store the heat from a heat-dissipating member or heat source. When the heat-absorbing material absorbs heat, the temperature of the heat-absorbing material is not changed at first. Instead, the temperature of the heat-absorbing material lags for a period of time at the melting point (about 35°C-70°C) thereof. The heat transmitted to the heat-absorbing material is absorbed without causing a rise in the temperature of the heat-absorbing material. The heat absorbed by the heat-absorbing particle is then dispersed to the environmental air. Thus, the heat from the heat-dissipating member or the heat source can be effectively absorbed, thereby maintaining normal operation of the device including the heat source. The core portion 2 of the heat-absorbing material may further include a dye to provide a desired color.

Fig. 2 is a schematic flowchart illustrating preparation of the heat-absorbing particle in accordance with the present invention and subsequent coating process. In this embodiment, the heat-absorbing material is tetradecanol, and an epoxy-polyester resin is used as a solvent. Firstly, an appropriate amount of prepolymer aqueous solution is prepared by means of mixing melamine (60 parts), formaldehyde (37%, 150 parts), and water (290 parts) together and then heating the mixture at 60°C for one hour (step S10). Next, preparing a mixture of molten tetradecanol and a dye at a ratio of about 1000 : 3 (the ratio can be optionally adjusted) until completely dissolved (step S12). The dyed tetradecanol is added into a solution of tween 80 (5 parts) and PVP (polyvinyl pyrrolidone, 20%, 50 parts), and the solution is then stirred to form an emulsion. The emulsion is added into the prepolymer aqueous solution and then heated at 60°C, and ethanoic acid is added until pH=6. The reaction is continued until a complete reaction is. obtained. After the reaction is complete, the temperature is lowered to the room temperature, and ammonia water is added until pH=9. A micro-capsulation procedure is thus complete (step S14). The obtained microcapsules are filtered and dried, and the resultant particles (i.e., micro-capsules) are the heat-absorbing particles in accordance with the present invention. It is noted that the heat-absorbing particles in accordance with the present invention can be produced by other suitable procedures, and the dye can be omitted.

Still referring to Fig. 2, for coating, 30 parts of microcapsules are dissolved and dispersed with 70 parts of epoxy-polyester resin (the solvent) (the ratio between the micro-capsules and the solvent can be optionally adjusted) at high temperature. The solution is then cooled and crushed to form a heat-absorbing coating material (step S18). The heat-absorbing coating material can be sprayed by a spray gun onto a surface of a metallic or non-metallic object (step S20).

In accordance with the present invention, a layer of heat-absorbing coating can be formed on a surface of any object. Since the layer includes a thermosetting material, certain strength and fixation are obtained. Of more importance, the heat-absorbing material of the heat-absorbing particle absorbs heat in an effective manner. The heat-absorbing coating can be coated on a large area of a casing of, e.g., a portable computer, and a conductive wire or conductive plate may be used to connect the heat-absorbing coating to the heat source, e.g., the central processing unit of the portable computer, thereby dissipating the heat generated by the central processing unit. The coating can also be coated on a casing in which the central processing unit is directly in contact with the casing (i.e., no conductive wire or conductive plate is provided between the central processing unit and the casing). The heat-absorbing particle containing the dyed heat-absorbing material may be called a "heat-absorbing pigment." Of course, the heat-absorbing particle needs not to be dyed. Nevertheless, the term "heat-absorbing pigment" referred to herein means a heat-absorbing particle containing a dyed heat-absorbing material, and the term "heat-absorbing particle" includes a dyed or not dyed heat-absorbing material. The heat-absorbing material without dye can be added into a solvent containing dye. Alternatively, the heat-dissipating particles in accordance with the present invention can be added into ordinary paint for subsequent coating on a surface of an object for heat-dissipating purpose. The heat-absorbing coating can be applied to heat-dissipating members and outer casing of computers, heat-dissipating members of machines, parts, heat-dissipating members, and outer casing of electric appliances, and parts, heat-dissipating members, outer casing of vehicles. Another advantage of the heat-absorbing coating is antioxidation without adversely affecting the heat-dissipating function. In addition, the heat-absorbing coating can be coated on a surface of any integrated circuit that requires heat-dissipation and/or antioxidation.

### Test

In order to prove the heat-absorbing effect of the heat-absorbing particles in accordance with the present invention, the heat-absorbing particles are coated on upper and lower surfaces of an aluminum plate of 10 mm x 10 mm ("the experimental plate"), and several points are selected on each of the upper and lower surfaces of the aluminum plate. For comparison, a comparative aluminum plate also of 10 mm x 10 mm ("the comparative plate") is provided, and corresponding points are selected on each of upper and lower surfaces of the comparative plate. As can be seen in Fig. 2, for each of the experimental plate and the comparative plate, points T1∼T8 are temperature-measuring points on the upper surface of the aluminum plate. Points B1∼B8 are temperature measuring points on the lower surface of the aluminum plate. A heater with a power of 10.8W is located on point B2 on the lower surface of the aluminum plate that is opposite to point T2 on the upper surface of the aluminum plate. The environmental temperature is 30°C. All of the points T1∼T8 and B1∼B8 are not coated with the coating. Table 1 shows the temperature detected at the points T1∼T8 and B1∼B8 respectively on the comparative plate and the experimental plate. As can be clearly seen in Table 1, the detected temperatures of the points T1∼T8 and B1∼B8 on the aluminum plate without coating (the comparative plate) are higher than those of the points T1∼T8 and B1∼B8 on the aluminum plate with coating (the experimental plate).

**Table 1**

| | comparative plate | experimental plate |
|---|---|---|
| B2 (heater) | 70.1°C | 43.45°C |
| T1 | 60.0°C | 40.8°C |
| T2 | 64.8°C | 43.0°C |
| T3 | 56.7°C | 39.6°C |
| T4 | 53.8°C | 38.1°C |
| T5 | 52.6°C | 36.9°C |
| T6 | 51.6°C | 36.4°C |
| T7 | 51.4°C | 36.4°C |
| T8 | 51.6°C | 36.5°C |
| B1 | 61.2°C | 42.1°C |
| B3 | 57.4°C | 40.1°C |
| B4 | 54.6°C | 38.6°C |
| B5 | 52.5°C | 36.8°C |
| B6 | 50.5°C | 36.3°C |
| B7 | 51.8°C | 36.4°C |
| B8 | 51.5°C | 36.2°C |

According to the above description, it is appreciated that the heat-absorbing particle in accordance with the present invention provides an excellent heat-absorbing effect. The heat-absorbing coating in accordance with the present invention can be coated on any surface of an object for heat-dissipation and/or antioxidation. Further, when the heat-absorbing coating layer has a color (i.e., the heat-absorbing material is dyed), an aesthetically pleasing effect may be provided without adversely affecting the heat-absorbing effect.

Although the invention has been explained in relation to its preferred embodiment, it is to be understood that many other possible modifications and variations can be made without departing from the scope of the invention as hereinafter claimed.

## Claims

1. A heat-absorbing particle having a diameter of 1∼1000 µm and comprising a shell portion (1) and a core portion (2), **characterized in that**: the shell portion (1) is made of a high molecular polymer selected from a group consisting of melamine-formaldehyde, urea-formaldehyde resins, polyurethanes, and acrylics, the core portion (2) is made of a heat-absorbing material that has a melting point at about 35°C-70°C and that is selected from a group consisting of straight chain alkanes, alcohols, and organic acids, a weight of the shell portion (1) is about 1/20 - 1/2 of that of the core portion (2).

2. The heat-absorbing particle as claimed in claim 1, wherein the heat-absorbing material is selected from a group consisting of paraffin, docosane, tetracosane, tetradecanol, hexadecanol, octodecanol, dodecanic acid, tetradecanoic acid, and hexadecanoic acid.

3. The heat-absorbing particle as claimed in claim 1, wherein the heat-absorbing material further includes a dye.
